# EUROPEAN PATENT APPLICATION

(11) **EP 0 662 659 A1**
(43) Date of publication of application: **12.07.1995**
(21) Application number: 94309353.4
(22) Date of filing: 14.12.1994
(51) Int. Cl.: G06F 11/00

(54) **Method for minimizing the effect of memory errors within a digital information storage system**

(30) Priority: 10.01.1994 US 178707
(71) Applicant: AT&T Corp., New York, NY 10013-2412 (US)
(72) Inventor: Shoji, Masakazu, Warren, New Jersey 07059 (US)
(74) Representative: Buckley, Christopher Simon Thirsk

(57) **Abstract**

A method is disclosed for the retrieval of digital information from a memory device wherein data representing temporally proximate samplings of a signal, or band-adjacent frequency components of a signal are stored in separate memory locations (132-137), each separate memory location being subject to circuit failure independent of other such memory locations. The effects of errors caused by memory circuit failures within the digital data system are reduced by testing for data losses upon retrieval of the information. In response to detecting a loss (e.g. in 132), data representing a signal sampling temporally proximate (e.g. in 133) to the signal sampling represented by the lost data is substituted for the lost data. In yet another method of the invention, a similar testing/substitution scheme is employed to reduce the effects of memory circuit failure errors. However, in response to detecting a data loss, data representing a frequency component adjacent to the band of the frequency component represented by the lost data is substituted for the lost data.

## Description

### Background Of The Invention

Storing digital audio or video of reasonable quality requires a great deal of memory. For example, it would require approximately 64 million memory sites to store 15 minutes of audio sampled at a rate of 64 kbits/s. Audio of higher quality and/or longer duration would naturally require even greater amounts of memory, and naturally, the same would be true for video. However, the capacity and density of semiconductor memory devices, particularly ROMs, have increased dramatically in recent years. As a result, the storage of substantial quantities of digitized audio and video information within such devices has become feasible.

Unfortunately, it is impossible to produce perfect large-capacity, high-density ROMs, while maintaining a high fabrication yield. The complexity of the devices, and the scale of integration simply preclude mass-production of such devices in which the operability of each individual memory site can be guaranteed. Because it is impossible to consistently produce a perfect large-capacity, high-density ROM, some type of quality assurance for the devices is obviously required, and this gives rise to a second difficulty. The sheer number of memory sites within such a ROM makes it very difficult to economically test if each memory site is operative. Such individual site testing becomes very time consuming as the number of sites within a memory device approach the number sites required to store an appreciable amount of digital audio or video information. In order to improve the economics of testing large-scale memory devices, only a sampling of the total memory sites within a given device are typically tested. This obviously results in a less than certain assurance of overall memory operability.

Furthermore, even if the operability of each memory site within a large-scale ROM was tested, it is only the functionality of the memory cell addressing circuits that is actually verified. There is no practical scheme for determining the integrity of information stored within the ROM. The only method presently available is reading the digital value stored at each site, and comparing that read value to a standard or master map of the information that is supposed to be stored in the memory. This read and compare method is too time consuming to be economically applied to large-capacity, high-density ROMs.

A lesson from standard audio phonograph records is useful. It is obviously impractical for a record manufacturer to test the entirety of the audio information contained on every record produced. The manufacturer could simply not afford to replay and monitor each track on each record in real time; naturally, this type of testing procedure has never been adopted in the mass production of phonograph records. For an audio or video information storage medium (digital or otherwise) to be practical for mass production, it must be of a design that allows a few easily implemented tests to ensure that the quality of signal retrieved from the medium will be of acceptable quality to a listener or viewer. The combination of previously available device designs, testing procedures, and information retrieval methods fails to provide this level of quality assurance or error correction for digitized signals stored upon large-capacity, high-density ROMs.

### Summary Of The Invention

The aforementioned problem is solved, in accordance with the principles of the invention, by providing a method for the retrieval of digital information from a memory device wherein data representing temporally proximate samplings of a signal, or band-adjacent frequency components of a signal are stored in separate memory locations; each of these separate memory locations being subject to circuit failure independent of other such memory locations. In practicing a particular method of the invention, the effects of errors caused by memory circuit failures within the digital data system are reduced by testing for data losses upon retrieval of the information. In response to detecting a loss, data representing a signal sampling temporally proximate to the signal sampling represented by the lost data is substituted for the lost data. In yet another method of the invention, a similar testing/substitution scheme is employed to reduce the effects of memory circuit failure errors. However, in response to detecting a data loss, data representing a frequency component adjacent to the band of the frequency component represented by the lost data is substituted for the lost data.

### Brief Description Of The Drawing

In the drawing:
FIG. 1 is a schematic diagram showing a portion of a high-density serial ROM that facilitates the practice of a particular method of the invention;
FIG. 2 is a simplified block diagram depicting the sequence in which data is stored within the various memory locations of the ROM of FIG. 1;
FIG. 3 is a schematic diagram showing a portion of a high-density parallel ROM that facilitates the practice of an alternate method of the invention; and
FIG. 4 is a simplified block diagram depicting the sequence in which data is stored within the various memory locations of the ROM of FIG. 3.

### Detailed Description

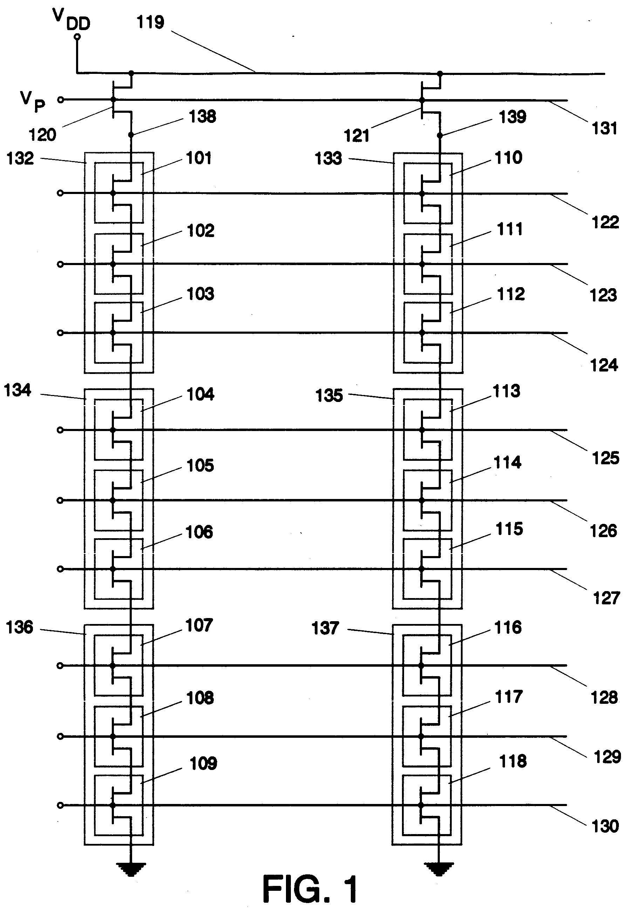

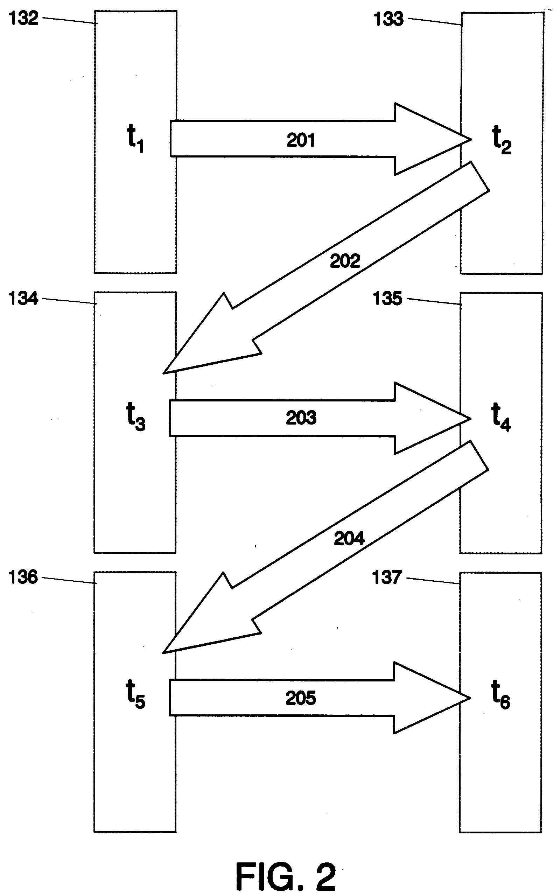

FIG. 1 provides a schematic diagram showing eighteen memory sites (101 through 118) within a portion of a high-density serial ROM. As is well known to those familiar with the art, digital values 0 and 1 are represented within this particular type of ROM by the presence of either an enhancement-mode (1) or a depletion-mode (0) FET at any given memory site. As shown in FIG. 1, there are two separate serial chains of memory site n-channel FETs -- sites 101 through 109 and sites 110 through 118. Each of these chains is connected to voltage supply line 119 (which has a positive voltage V_{DD} applied to it) by a p-channel FET (labeled 120 and 121). The gate of each memory site n-channel FET is connected to a wordline conductor (labeled 122 through 130), and the gate of each p-channel FET is connected to conductor 131. Each serial p-channel/n-channel FET arrangement provides a switchable path between voltage supply line 119 and ground. Data stored within the portion of the serial ROM shown in FIG. 1 represents a digitized audio signal of duration 6t, which was sampled over six equal intervals t; these samplings being performed sequentially at times t₁, t₂, t₃, t₄, t₅ and t₆. To facilitate the practice of a particular method of the invention, the two serial FET chains shown in FIG. 1 are paired with each other so that the storage of data representing chronological samplings of an audio signal is avoided within a single chain. This serves to reduce the probability of two consecutive chronological samplings being lost or corrupted due to a memory circuit failure, as each chain will be subject to various errors independently of the other. To this end, three bits of data representing the audio signal at t₁ are stored at memory sites 101, 102 and 103 (collectively labeled as memory location 132); three bits of data representing the audio signal at t₂ are stored at memory sites 110, 111 and 112 (collectively labeled as memory location 133); three bits of data representing the audio signal at t₃ are stored at memory sites 104, 105 and 106 (collectively labeled as memory location 134); three bits of data representing the audio signal at t₄ are stored at memory sites 113, 114 and 115 (collectively labeled as memory location 135); three bits of data representing the audio signal at t₅ are stored at memory sites 107, 108 and 109 (collectively labeled as memory location 136); and three bits of data representing the audio signal at t₆ are stored at memory sites 116, 117 and 118 (collectively labeled as memory location 137). This sequence in which audio data is stored within the various three bit memory locations is illustrated in FIG. 2 by arrows 201 through 205.

To read data from a particular memory site within the ROM of FIG. 1, the wordline conductor contacting the gate of the particular n-channel FET at that memory site is grounded, while the wordline conductors contacting all the other n-channel FET gates within the ROM are connected to a voltage of V_{DD}. For example, to read the value stored at memory site 101, a voltage of V_{DD} is applied to wordline conductors 123 through 130, wordline conductor 122 is grounded, and a voltage V_{P} is applied to the gate of p-channel FET 120. Voltage V_{P} is fixed at a potential that causes the source-to-drain conductivity of p-channel FET 120 to become equal to the total conductivity of the serial memory circuit consisting of sites 101 through 109 that would be obtained if a voltage equal to V_{DD} were applied to all of the wordline conductors (122 through 130). With these voltages applied, if the n-channel FET at memory site 101 is a depletion-mode FET, current will flow from voltage supply line 119 to ground via serial a path provided by p-channel FET 120 and the n-channel FETs at memory sites 101 through 109. This current flow is indicative of a digital 0 stored at memory site 101. However, if the n-channel FET at memory site 101 is an enhancement-mode FET, a current path between voltage supply line 119 to ground will not be provided. No current flowing is indicative of a digital 1 stored at memory site 101. The presence or absence of a current flow through p-channel FET 120 and the n-channel FETs at memory sites 101 through 109 can be detected by measuring the voltage evident at node 138. A voltage of approximately 0.5V_{DD} at this node indicates current is flowing, while a voltage of approximately V_{DD} indicates no current flow. It should be noted that the data stored at memory site 110 may also be read when wordline conductor 122 is grounded, and a voltage of V_{DD} is applied to all other wordlines. Of course, the value of the data at memory site 110 will be indicated by the presence or absence of current flowing through the serial path provided by p-channel FET 121 and the n-channel FETs at memory sites 110 through 118, and an indicative voltage measurement would have to taken at node 139.

It is well known that when circuits like the one illustrated in FIG. 1 are fabricated on silicon or any other semiconductor material, failures will occur due to processing imperfections. For example, if the n-channel FET at memory site 103 were to be shorted to ground as the result of a processing imperfection, the data stored in memory sites 103 through 109 would read as digital 0s, regardless of the actual values stored at those sites. That is to say, current would appear to flow from voltage supply line 119 to ground via a path provided by p-channel FET 120 and the serial memory circuit consisting of sites 101 through 109, when any of these seven memory sites were read. However, the serial memory circuit consisting of sites 101 through 109 would be partially operative as the data stored at sites 101 and 102 could still be read correctly. Another error condition could be introduced if control of the n-channel FET at memory site 103 were to be lost due to a circuit control problem, or a processing imperfection, and that particular n-channel FET was made to conduct at all times. This would cause the data stored at site 103 to read as a digital 0 regardless of its actual value, but the data stored at all the other memory sites in the serial memory circuit consisting of sites 101 through 109 would remain correctly readable. A potentially more serious data error condition would occur if an n-channel FET at one of memory sites 101 through 109 were to be placed in a perpetually non-conducting state due to a processing imperfection or a circuit control error. In that case, all the data stored in the serial memory circuit consisting of sites 101 through 109 would read as digital 1 (i.e., no current path between voltage supply line 119 and ground could be provided by p-channel FET 120 and the serial memory circuit consisting of sites 101 through 109). This type of memory site failure, in which a single imperfection results in the loss of all data in an entire serial memory circuit, is called a primary failure.

For the ROM of FIG. 1, when a primary memory failure occurs, all the values read out from a serial memory circuit are digital 1. If such a string of incorrect values were provided to a digital audio processor, the result would be an unfaithful reproduction of a portion of the digital audio signal stored in the ROM. This unfaithful reproduction would be detected as noise by a listener.

The invention reduces the unwanted noise resulting from primary memory failures by employing a novel method of error detection and conditional data substitution. The data representing a digitized audio signal stored within a ROM is typically read, in chronological order, by an audio processor that then processes the data to produce sound. The method of the invention conditionally modifies this process. In practicing the invention, the combination "1-1-1" is never used as a three-bit sequence to represent an audio signal stored within the ROM of FIG. 1 (only seven of the possible eight three-bit combinations are valid for data representation). By restricting the set of valid data representations, primary memory failures can be readily detected. For example, since "1-1-1" cannot be a valid data sequence, if the values of the data at memory sites 101, 102 and 103 (all of which represent the audio signal at time t₁) are all read as 1, a primary failure can be assumed to have occurred with one of the n-channel FETs in the chain consisting of sites 101 through 109. In accordance with the invention, the system (typically a microprocessor controlled digital audio processor system) reading the ROM is programmed to recognize this "1-1-1" primary failure state, discard the data read from memory sites 101, 102 and 103, and immediately read the data stored at memory sites 110, 111, and 112 (all of which represent the audio signal at time t₂). These "substitute" values read from the memory sites associated with the audio signal at time t₂ are provided to the audio processor that uses this data in lieu of the t₁ values read from memory sites 101 through 103.

The process of reading the values stored in the memory sites of the ROM of FIG. 1 is then continued in chronological order. Memory sites 110 through 112 are read next, and subjected to the same type of primary failure state test. If the data at these memory sites is found to be "1-1-1" the system discards the data and immediately reads the data stored at memory sites 101, 102, and 103 (all of which represent the audio signal at time t₁). These "substitute" t₁ values are provided to the audio processor in lieu of the t₂ values read from memory sites 110 through 112.

This testing/conditional substitution procedure is repeated for the data stored in sites 104 through 106 (t₃), 113 through 115 (t₄), 107 through 109 (t₅), and finally for sites 116 through 118 (t₆). If a "1-1-1" failure state is detected for any of the three-bit data site groupings in the chain consisting of sites 101 through 109, the system substitutes data from the next chronological period (tₙ₊₁). While if a "1-1-1" failure state is detected for any of the data site groupings in the chain consisting of sites 110 through 118, the system substitutes data from the previous chronological period (tₙ₋₁). Since audio signals do not typically vary randomly from one instant to another, the characteristics (i.e., amplitude, pitch, etc.) of a given sound are usually related to the characteristics of the sound just before and just after it (assuming the sound is being sampled at a fairly high rate). Consequently, substituting data representing the audio signal at time tₙ₊₁ or tₙ₋₁ (data temporally proximate to tₙ) for the corrupted data retrieved from the sites associated with tₙ results in the production of an audio signal that is perceived by a listener as having a higher quality (less noise) than one that would have been produced in response to the corrupted data. The invention effectively stretches the digitized audio signal for time tₙ₊₁ or tₙ₋₁ to mask the gap created by the loss of the data for time tₙ. Naturally, if no primary failures are detected for the data stored within the ROM of FIG. 1, the data is simply read in chronological order and no substitutions are performed.

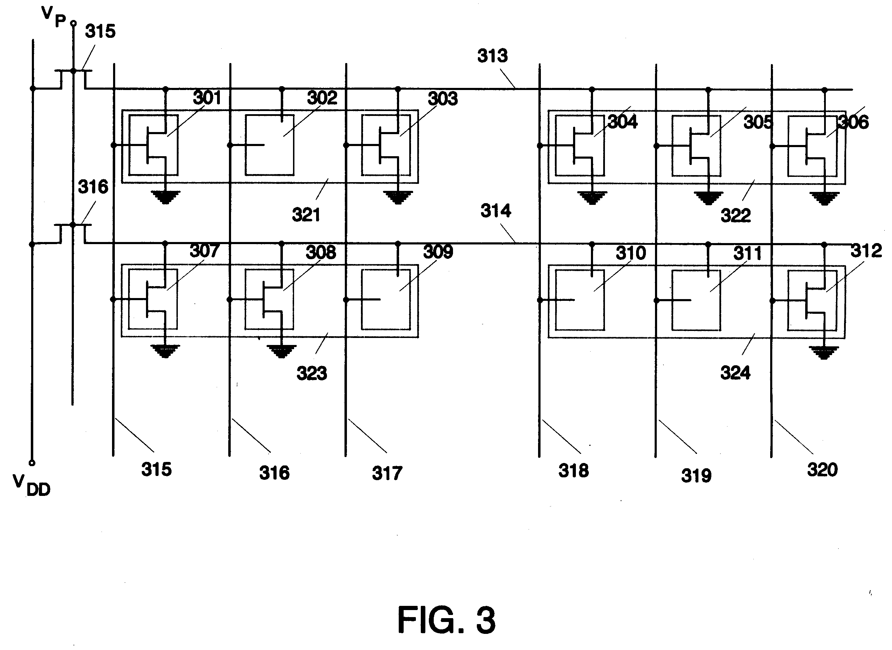

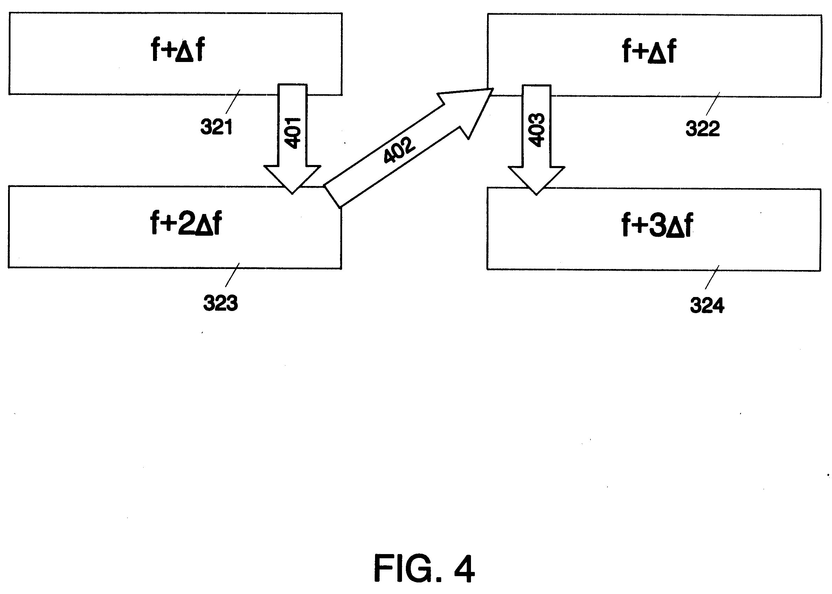

FIG. 3 is a schematic diagram showing a portion of a high-density parallel ROM that facilitates the practice of an alternate method of the invention. In this particular ROM, a digital 1 is represented by the presence of an enhancement-mode FET at any given memory site, and a digital 0 is represented by the absence of an FET at a memory site. As shown in FIG. 3, there are two separate parallel arrangements of memory sites -- sites 301 through 306, and sites 307 through 312. Each of these arrangements is connected to a separate bitline conductor (313 and 314). A positive voltage V_{DD} is applied to bitline conductors 313 and 314 via p-type FETs (315 and 316, respectively). The gate of each memory site FET is connected to a wordline conductor (labeled 315 through 320). A voltage V_{P} is applied to the gates of p-type FETs 315 and 316 to enable the reading of the ROM (similar to the method in which a voltage V_{P} was applied to the ROM of FIG. 1). Data stored within the portion of the serial ROM shown in FIG. 3 is a frequency domain representation of a video signal component at frequency f, f+Δf, f+2Δf and f+3Δf; where Δf<<f. The two parallel memory site arrangements are paired so that the storage of video data representing frequency domain data components separated by Δf is avoided within a single group (thereby reducing the probability of two band-adjacent frequency components being lost or corrupted due to a single memory circuit failure). Three bits of data representing the component of the video signal at frequency f are stored at memory sites 301, 302 and 303 (collectively labeled memory location 321); three bits of data representing the component video signal at f+Δf are stored at memory sites 307, 308 and 309 (collectively labeled memory location 322); three bits of data representing the component of the video signal at f+2Δf are stored at memory sites 304, 305 and 306 (collectively labeled memory location 323); and three bits of data representing the component of the video signal at f+3Δf are stored at memory sites 310, 311 and 312 (collectively labeled memory location 324). The sequence in which video data is stored within the various three bit memory locations is illustrated in FIG. 4 by arrows 401 through 403.

For the ROM of FIG. 3, primary failures resulting in the loss of all data within a parallel arrangement of FETs would occur if one of the bitline conductors (313 or 314) were to be permanently shorted to ground (due to either a circuit control problem, or a processing imperfection). In this failure mode, all of the stored values in the memory sites of that parallel arrangement would read as digital 0s -- regardless of their true value (current would continually flow between the bitline conductors and ground). For this reason, the combination "0-0-0" is never used as a three-bit sequence representing a video signal component (only seven of the possible eight three-bit combinations are valid for data representation). This being the case, if the values of the data at memory sites 301, 302 and 303 (all of which represent the video signal component for frequency f) are all read as 0s, a primary failure can be assumed to have occurred within parallel arrangement consisting of sites 301 through 306. In accordance with the invention, the system reading the ROM recognizes this "0-0-0" primary failure state, discards the data read from memory sites 301, 302 and 303, and immediately reads the data stored at memory sites 307, 308, and 309 (all of which represent the video signal component for frequency f+Δf). These "substitute" values read from the memory sites associated with the video component at frequency f+Δf are provided to the video processor in lieu of the values read from memory sites 301 through 303.

The testing/conditional substitution procedure is repeated for the data stored in sites 304 through 306 (data related to frequency component f+2Δ), and finally for sites 316 through 318 (data related to frequency component f+3Δf). If a "0-0-0" failure state is detected for any of the three-bit data site groupings in the parallel arrangement consisting of sites 301 through 306, the system substitutes data from the adjacent higher frequency component. While if a "0-0-0" failure state is detected for any of the data site groupings in the chain consisting of sites 307 through 312, the system substitutes data from the adjacent lower frequency component. If there are no primary failures detected for the data stored within the ROM of FIG. 3, the content of the ROM are read in order, and no substitutions are performed.

It will be understood that the particular methods described above are only illustrative of the principles of the present invention, and that various modifications could be made by those skilled in the art without departing from the scope and spirit of the present invention, which is limited only by the claims that follow. One such modification would include employing the technique of the invention upon three or more serial or parallel memory sites (as opposed to a pair). For example, applying the invention to a trio of serial or parallel memory sites containing time domain data representing an audio signal, the first member of the trio would store data representing the signal at times t₁, t₄, t₇..., the second member would store data representing the signal at times t₂, t₅, t₈..., and the third member would store data representing a the signal at times t₃, t₆, t₉.... If a primary failure state is detected within the first or second members of the trio, the system substitutes data from the next chronological period (tₙ₊₁). However, if a primary failure state is detected within the third member of the trio, the system substitutes data from the previous chronological period (tₙ₋₁). The method of the invention can be extended to accommodate any number of data substitution schemes -- In most cases, either the next or the previous data may be substituted for lost data; one doesn't provide any qualitative advantage over the other. Noise will be reduced as long as the substituted data is temporally proximate or band-adjacent (depending upon whether it is time or frequency domain data) to the lost data. Furthermore, it will be also be clear that the invention is applicable to any stored digital signal or information in which data losses may be effectively masked by the substitution of temporally proximate or band-adjacent data (digital audio and video signals are merely two examples of such).

## Claims

1. In a digital data storage system including a plurality of separate memory locations, each of which is subject to circuit failure independent of other of said separate memory locations;
a method for the storage of digital information wherein digital data representing a signal sampled at a given time is stored at each of said memory locations so that digital data representing temporally proximate samplings of said signal are stored in separate memory locations.

2. In a digital data storage system including a plurality of separate memory locations, each of which is subject to circuit failure independent of other of said separate memory locations;
a method for the storage of digital information wherein digital data representing a signal sampled at a given frequency band is stored at each of said memory locations so that digital data representing adjacent frequency bad samplings of said signal are stored in separate memory locations.

3. The method of claim 1 or 2 wherein said stored digital data represents a video signal.

4. The method of claim 1 or 2 wherein said stored digital data represents an audio signal.

5. In a digital data storage system including:
a digital signal processor; and
a plurality of memory locations, each of which contains digital data representing an signal sampled at a given time, said digital data being stored within said memory locations so that digital data representing temporally proximate samplings of said signal are stored in separate memory locations, each of said separate memory locations being subject to circuit failure independent of other of said memory locations;
a method for the retrieval of digital information comprising the steps of:
testing the operability of said memory locations upon retrieval of the digital data representing said signal sampled at a given time t;
retrieving digital data representing a sampling of said signal at a time temporally proximate to t, in response to detecting that a given memory location being utilized for the storage of digital data representing said signal sampled at said given time t is inoperative; and
providing said retrieved digital data representing a sampling of said signal at a time temporally proximate to t to said digital signal processor in lieu of said data stored in said inoperable memory location.

6. The method of claim 5 wherein said retrieved digital data representing a sampling of said signal at a time temporally proximate to t, is representative of said signal sampled at a time following said given time t.

7. The method of claim 5 wherein said retrieved digital data representing a sampling of said signal at a time temporally proximate to t, is representative of said signal sampled at a time preceding said given time t.

8. In a digital data storage system including:
a digital signal processor; and
a plurality of memory locations, each of which contains digital data representing an signal sampled at a given frequency band, said digital data being stored within said memory locations so that digital data representing adjacent frequency band samplings of said signal are stored in separate memory locations, each of said separate memory locations being subject to circuit failure independent of other of said memory locations;
a method for the retrieval of digital information comprising the steps of:
testing the operability of said memory locations upon retrieval of the digital data representing a frequency component of said signal sampled at frequency f;
retrieving digital data representing a frequency component of said signal sampled at a frequency band adjacent to f, in response to detecting that a given memory location being utilized for the storage of digital data representing said frequency component of said signal sampled at frequency f is inoperative; and
providing said retrieved digital data representing said frequency component of said signal sampled at frequency band adjacent to f to said digital signal processor in lieu of said data stored in said inoperable memory location.

9. The method of claim 8 wherein said retrieved digital data representing said frequency component of said signal sampled at frequency band adjacent to f, is representative of said signal sampled at frequency greater than f.

10. The method of claim 8 wherein said retrieved digital data representing said frequency component of said signal sampled at frequency band adjacent to f, is representative of said signal sampled at frequency less than f.
